# EUROPÄISCHE PATENTSCHRIFT

(11) **EP 4 179 126 B1**
(45) Veröffentlichungstag und Bekanntmachung des Hinweises auf die Patenterteilung: **24.01.2024**
(21) Anmeldenummer: 21746336.3
(22) Anmeldetag: 01.07.2021
(51) Int. Cl.: C23C 14/26, C23C 14/50, C23C 14/56, B29D 11/00

(54) **VORRICHTUNG ZUM AUFNEHMEN EINES GEGENSTANDS IN EINER VAKUUMBESCHICHTUNGSANLAGE**
APPARATUS FOR ACCOMMODATING AN ARTICLE IN A VACUUM-COATING INSTALLATION
APPAREIL DESTINÉ À RECEVOIR UN ARTICLE DANS UNE INSTALLATION DE REVÊTEMENT SOUS VIDE

(30) Priorität: 13.07.2020 DE 102020118367
(43) Veröffentlichungstag der Anmeldung: 17.05.2023
(73) Patentinhaber: Carl Zeiss Vision International GmbH, 73430 Aalen (DE)
(72) Erfinder: MACIONCZYK, Frank, 73447 Oberkochen (DE); GREEN, Erwin, 73432 Aalen (DE)
(74) Vertreter: Pfiz/Gauss Patentanwälte PartmbB
(86) Internationale Anmeldenummer: PCT/EP2021/068190
(87) Internationale Veröffentlichungsnummer: WO 2022/012955

(56) Entgegenhaltungen:
- EP-A1- 0 385 157
- EP-A1- 0 406 484
- DE-A1-102006 041 137
- DE-T2- 69 200 590

## Beschreibung

Die Erfindung betrifft eine Vorrichtung zum Aufnehmen eines Gegenstands in einer Vakuumbeschichtungsanlage mit einem Träger, der eine Beschichtungsöffnung aufweist, mit einer Halteeinrichtung zum Halten des Gegenstands in der Beschichtungsöffnung, und mit einem Schwenklager für die Halteeinrichtung, das an dem Träger festgelegt ist, das eine Schwenkachse hat, um welche die Halteeinrichtung für das Wenden des damit gehaltenen Gegenstands in der Beschichtungsöffnung geschwenkt werden kann und das einen Lagerkörper mit einer umfänglich geschlossenen Aufnahme für einen in die Richtung der Schwenkachse erstreckten Rundkörper hat. Die Erfindung betrifft außerdem ein Verfahren zum Anordnen einer Halteeinrichtung mit einem darin festgelegten Gegenstand an dem Träger der Vorrichtung, eine Handhabungsvorrichtung hierfür sowie ein Computerprogrammprodukt.

Zur Entspiegelung von Brillengläsern werden dünne optische Schichten auf die Linsenoberflächen aufgetragen. Die Entspiegelungsschichten werden in Vakuumbeschichtungsanlagen hergestellt. In Vakuumbeschichtungsanlagen können optisch wirksame Materialien im Hochvakuum aus einer Verdampferquelle heraus verdampft oder aus einer Sputterquelle heraus gesputtert und auf den Brillengläsern abgeschieden werden.

Aus der DE 10 2006 041 137 A1 ist eine Vorrichtung der eingangs genannten Art bekannt. Diese Vorrichtung hat einen Träger, der in einer Vakuumkammer einer Vakuumbeschichtungsanlage um eine vertikale Drehachse bewegt werden kann. Der Träger weist einen Körper mit einer Kalotte auf, an der eine Vielzahl Halteeinrichtungen mit darin festgelegten, zu beschichtenden Gegenständen in Schwenklagern aufgenommen sind, die in einer Beschichtungsöffnung mittels Magnetkraft gewendet werden können.

Damit wird erreicht, dass zwei einander gegenüberliegende Oberflächen von Gegenständen in der Vorrichtung im Vakuum beschichtet werden können, ohne dass die Vakuumkammer nach einem ersten Beschichtungsvorgang für das Wenden von Gegenständen belüftet werden muss, wodurch sich eine Gesamtprozesszeit erheblich verringern lässt.

Die aus der DE 10 2006 041 137 A1 bekannten Halteeinrichtungen haben jeweils Lagerbolzen, die bei Anordnen einer Halteeinrichtung an dem Träger in eine Aufnahme in einem Lagerkörper der Schwenklager eingeführt werden müssen. Um die Lagerbolzen in die Aufnahme eines Lagerkörpers leicht einführen zu können, hat diese gegenüber dem Lagerbolzen ein Übermaß. Unsorgfältiges Arbeiten beim Anordnen von Halteeinrichtungen an dem Träger kann hier zur Folge haben, dass eine Halteeinrichtung nur mit einem von zwei Lagerbolzen in den Schwenklagern gehalten wird. In einer Vakuumbeschichtungsanlage kann dann eine solche Halteeinrichtung mit dem darin festgelegten Gegenstand nicht mehr gewendet werden. Darüber hinaus besteht hier die Gefahr, dass sich eine Halteeinrichtung aus einer Aufnahme in einem Schwenklager selbsttätig löst und dann andere, auf dem Träger für das Beschichten angeordnete Gegenstände beschädigt.

In der DE 692 00 590 T2, der EP 0 406 484 A1 und der EP 0 385 157 A1 sind jeweils kalottenförmige Substratträger mit mehreren Öffnungen beschrieben, in denen jeweils ringförmige Träger zum Einspannen von Brillengläsern befestigt sind. Die ringförmigen Träger sind schwenkbar, so dass darin eingespannte Brillengläser um 180° gedreht werden können. Die Rotation der Ringe um die Achse, die durch den Mittelpunkt senkrecht zum Radius verläuft, wird durch diametral am Umfang der Ringe angeordnete Drehzapfen ermöglicht, die in Lagern aufgenommen sind.

Aufgabe der Erfindung ist es, eine Vorrichtung zum Aufnehmen eines Gegenstands in einer Vakuumbeschichtungsanlage anzugeben, die ein sicheres Halten des Gegenstands während des Beschichtungsvorgangs gewährleistet und die es ermöglicht, dass ein zu beschichtender Gegenstand an einem Träger mit einfachen Bewegungen so angeordnet werden kann, dass sich dieser in der Vakuumbeschichtungsanlage wenden lässt.

Diese Aufgabe wird durch die in Anspruch 1 angegebene Vorrichtung, durch die in Anspruch 12 und 13 angegebenen Verfahren, die in Anspruch 14 angegebene Handhabungsvorrichtung sowie das in Anspruch 15 angegebene Computerprogrammprodukt gelöst. Vorteilhafte Weiterbildungen der Erfindung sind in den abhängigen Ansprüchen angegeben.

Eine erfindungsgemäße Vorrichtung zum Aufnehmen eines Gegenstands in einer Vakuumbeschichtungsanlage hat einen Träger, der eine Beschichtungsöffnung aufweist, sowie eine Halteeinrichtung zum Halten des Gegenstands in der Beschichtungsöffnung, und ein Schwenklager für die Halteeinrichtung, das an dem Träger festgelegt ist, das eine Schwenkachse hat, um welche die Halteeinrichtung für das Wenden des damit gehaltenen Gegenstands in der Beschichtungsöffnung geschwenkt werden kann und das einen Lagerkörper mit einer umfänglich geschlossenen Aufnahme für einen in die Richtung der Schwenkachse erstreckten Rundkörper hat und das zusätzlich eine umfänglich offene Aufnahme für den Rundkörper aufweist, sodass der Rundkörper bei Anordnen der Halteeinrichtung an dem Träger durch die umfänglich offene Aufnahme in die umfänglich geschlossene Aufnahme eingeführt werden kann.

Unter Vakuumbeschichtungsanlage ist vorliegend eine Anlage zu verstehen, mit der unter Vakuum-, insbesondere Hochvakuum-Bedingungen, Gegenstände beschichtet werden können. Vakuumbeschichtungsanlagen sind beispielsweise Kathodenzerstäubungsanlagen, auch Sputteranlagen genannt, Bedampfungsanlagen oder chemische Gasphasenabscheidungsanlagen.

Ein in einer erfindungsgemäßen Vorrichtung aufzunehmender Gegenstand ist insbesondere ein optisches Element. Unter einem optischen Element wird dabei ein Gebrauchsgegenstand verstanden, der eine elektromagnetische Strahlung, wie z. B. sichtbares Licht, UV- oder IR-Strahlung absorbierende, transmittierende, reflektierende, brechende oder streuende Funktion hat. Als optische Elemente werden vorliegend z. B. Linsen, beispielsweise Brillenlinsen oder Kontaktlinsen angesehen, aber auch Plan- und Rundoptiken, Prismen, Spiegel, sphärische oder asphärische Gläser, formgerandete Brillengläser oder elliptische Gläser etc. verstanden. Ein in einer erfindungsgemäßen Vorrichtung aufzunehmender Gegenstand kann allerdings auch ein Werkzeug wie z. B. ein Bohrer oder ein Fräskopf sein.

Eine umfänglich geschlossene Aufnahme bezeichnet vorliegend eine Aufnahme für einen Körper, z. B. einen Lagerbolzen, die nach Einführen des Körpers in die Aufnahme in Bezug auf die Querschnittsebene orthogonal zur Einführungsrichtung den Körper vollständig umschließt.

Eine umfänglich offene Aufnahme bezeichnet vorliegend eine Aufnahme für einen Körper, z. B. einen Lagerbolzen, die nach Einführen des Körpers in die Aufnahme in Bezug auf die Querschnittsebene orthogonal zur Einführungsrichtung den Körper nur teilweise umschließt. Vorzugsweise bedeutet teilweise, dass die umfänglich offene Aufnahme den Körper wenigstens halb, weiter vorzugsweise wenigstens zu drei Vierteln umschließt.

Die umfänglich geschlossene Aufnahme des Lagerkörpers kann in die umfänglich offene Aufnahme des Lagerkörpers übergehen oder von dieser beabstandet angeordnet sein.

Vorteilhaft ist es, wenn die umfänglich offene Aufnahme des Lagerkörpers der Beschichtungsöffnung des Trägers zugewandt ist und wenn die Ausdehnung der umfänglich offenen Aufnahme des Lagerkörpers in Richtung der Schwenkachse wenigstens 50% und maximal 100% des Abstands zwischen der umfänglich geschlossenen Aufnahme des Lagerkörpers und der Beschichtungsöffnung beträgt. Diese Maßnahme stellt sicher, dass die Halteeinrichtung mit dem Gegenstand in der Beschichtungsöffnung platziert und dort gewendet werden kann und dass die umfänglich offene Aufnahme des Lagerkörpers ausreichend groß ist, um ein Herausbewegen des Rundkörpers aus dem Lagerkörper zu verhindern.

Eine bevorzugte Ausführungsform sieht vor, dass die umfänglich offene Aufnahme des Lagerkörpers eine auf einer dem Träger abgewandten Seite des Lagerkörpers angeordnete Öffnung hat. Besonders bevorzugt ist dabei die Öffnung in der umfänglich offenen Aufnahme derart angeordnet, dass sie eine Verlagerung des Rundkörpers in zwei Raumrichtungen, nämlich in die Richtung der Schwenkachse und in eine Richtung näherungsweise orthogonal zur Oberfläche des Trägers, erlaubt. Dies hat den Vorteil, dass die Wahrscheinlichkeit für ein Herausbewegen des Rundkörpers aus dem Schwenklager minimiert wird.

Besonders bevorzugt weist die umfänglich offene Aufnahme des Lagerkörpers dabei eine U-Form auf. Vorteilhafterweise weist der Halbkreis der U-Form dabei den gleichen Radius auf wie die umfänglich geschlossene Aufnahme des Lagerkörpers. Weiter vorteilhaft liegen die dem aufzunehmenden Körper zugewandten Seiten der umfänglich offenen Aufnahme des Lagerkörpers in den Tangentialebenen der dem aufzunehmenden Körper zugewandten Seiten der umfänglich geschlossenen Aufnahme. Diese Maßnahmen haben den Vorteil, dass in dem Fall des Herausbewegens des Rundkörpers aus der umfänglich geschlossenen Aufnahme in die umfänglich offene Aufnahme eine weitere Verlagerung des Rundkörpers auf die Richtung der Öffnung der umfänglich offenen Aufnahme beschränkt ist. Zudem sorgen die den Rundkörper umgebenden Wände der umfänglich offenen Aufnahme dafür, dass der Rundkörper wieder zurück in die umfänglich geschlossene Aufnahme geführt wird. Insbesondere ist es hierfür hilfreich, wenn sich die umfänglich geschlossene Aufnahme des Lagerkörpers unterhalb von der umfänglich offenen Aufnahme des Lagerkörpers befindet. Denn in diesem Fall bewirkt das Eigengewicht des Rundkörpers bzw. der Halteeinrichtung und/oder die Bewegung des Trägers, z. B. eine Rotation des Trägers, während des Beschichtungsvorgangs ein Zurückbewegen des Rundkörpers in die umfänglich geschlossene Aufnahme des Lagerkörpers. Auf diese Weise ist die Lagerung der Halteeinrichtung in dem Lagerkörper besonders sicher.

Der Rundkörper kann ein an die Halteeinrichtung angeschlossener Lagerbolzen sein. In diesem Fall wird der Lagerbolzen in die Aufnahme des Lagerkörpers eingeführt, um die Halteeinrichtung mit dem Gegenstand an dem Träger zu halten.

Es ist weiterhin von Vorteil, wenn die umfänglich geschlossene Aufnahme gegenüber dem Rundkörper ein Übermaß hat. Dieses Übermaß erlaubt es dem Rundkörper, sich in dem Lagerkörper zu bewegen, z. B. durch eine Rotation oder eine Verlagerung. Vorzugsweise entspricht der Durchmesser der umfänglich geschlossenen Aufnahme des Lagerkörpers zwischen 101% und 150%, besonders bevorzugt zwischen 110% und 140%, ganz besonders bevorzugt zwischen 120% und 130% des Durchmessers des Rundkörpers. Dieses Übermaß hat den Vorteil, dass sich der Rundkörper in dem Lagerkörper bewegen kann, dass sich aber gleichzeitig der Winkel der Schwenkachse während des Wendens der Halteeinrichtung nur wenig ändern kann.

Eine bevorzugte Ausführungsform sieht ein weiteres Schwenklager für das schwenkbewegliche Lagern der Halteeinrichtung um eine Schwenkachse an dem Träger vor, das für das Wenden des mit der Halteeinrichtung gehaltenen Gegenstands in der Beschichtungsöffnung dient und das einen weiteren Lagerkörper mit einer umfänglich geschlossenen Aufnahme für einen in die Richtung der Schwenkachse erstreckten weiteren Rundkörper hat. Der weitere Rundkörper kann in das weitere Schwenklager und der Rundkörper in das Schwenklager eingeführt werden, sodass die Halteeinrichtung in der Beschichtungsöffnung gewendet werden kann.

Vorteilhafterweise befindet sich dabei das Schwenklager unterhalb von dem weiteren Schwenklager, da dadurch das Einführen des Rundkörpers in das Schwenklager und des weiteren Rundkörpers in das weitere Schwenklager vereinfacht wird. Der weitere Rundkörper kann nämlich zuerst in die umfänglich geschlossene Aufnahme des weiteren Lagerkörpers des weiteren Schwenklagers eingeführt werden und dann der Rundkörper durch die umfänglich offene Aufnahme des Lagerkörpers des Schwenklagers in die umfänglich geschlossene Aufnahme des Lagerkörpers des Schwenklagers gleiten.

Der weitere Lagerkörper kann dabei ebenfalls eine in die umfänglich geschlossene Aufnahme übergehende umfänglich offene Aufnahme für den weiteren Rundkörper aufweisen, durch die der weitere Rundkörper bei Anordnen der Halteeinrichtung an dem Träger in die umfänglich geschlossene Aufnahme eingeführt werden kann. Diese Maßnahme erleichtert das Einführen des weiteren Rundkörpers in den weiteren Lagerkörper des weiteren Schwenklagers.

Die Anordnung der umfänglich offene Aufnahme für den Rundkörper an dem Träger hat hier die technische Wirkung, dass bei einem Herausbewegen des Rundkörpers aus der umfänglich geschlossenen Aufnahme des Lagerkörpers der Rundkörper von der umfänglich offenen Aufnahme des Lagerkörpers derart geführt wird, dass er sich z. B. durch sein Eigengewicht oder das Eigengewicht der Halteeinrichtung oder durch die Bewegung des Trägers während des Beschichtungsvorgangs wieder in die umfänglich geschlossene Aufnahme zurückbewegt.

Zudem vereinfacht die umfänglich offene Aufnahme das Einführen des Rundkörpers in die umfänglich geschlossene Aufnahme des Lagerkörpers. Um den Rundkörper in die umfänglich geschlossene Aufnahme des Lagerkörpers einzuführen, muss diese nämlich nicht in allen drei Raumrichtungen korrekt geführt werden. Stattdessen kann der Rundkörper in die umfänglich offene Aufnahme eingeführt werden und von dort in die umfänglich geschlossene Aufnahme. Ist die Halteeinrichtung an dem Träger derart gelagert, dass die Halteeinrichtung einen ausreichend großen Winkel mit der horizontalen Ebene bildet, kann sich der Rundkörper nach Einführung in die umfänglich offene Aufnahme des Lagerkörpers auch selbstständig in die umfänglich geschlossene Aufnahme hinein bewegen.

Eine Idee der Erfindung ist, dass diese vereinfachte Art des Einführens des Rundkörpers in die umfänglich geschlossene Aufnahme des Lagerkörpers ein automatisches von einer Steuereinheit mit einer Rechnereinheit und einem Computerprogramm durchgeführtes Einführen des Rundkörpers in die umfänglich geschlossene Aufnahme des Lagerkörpers ermöglicht. Dies spart insbesondere Zeit bei dem Beschichtungsvorgang.

Von Vorteil ist es, wenn der weitere Lagerkörper an dem Träger festgelegt ist, denn dies ermöglicht ein sicheres Halten der Halteeinrichtung an dem Träger während des Beschichtungsvorgangs.

Der weitere Rundkörper kann ebenfalls als ein an die Halteeirichtung angeschlossener Lagerbolzen ausgebildet sein.

Eine vorstehend angegebene Vorrichtung zum Aufnehmen eines Gegenstands in einer Vakuumbeschichtungsanlage ermöglicht, dass Verluste aufgrund von Beschädigungen der Gegenstände, z. B. Beschädigungen von Gläsern vermieden werden. Außerdem wird der Vorgang für das Einlegen der Halteeinrichtung in das Schwenklager erleichtert und damit zeitlich verkürzt. Zusätzlich kann das erfindungsgemäße Schwenklager für ein automatisches Einlegeverfahren genutzt werden, das zu Einsparung von Zeit und Arbeitskraft bei der manuellen Handhabung der Gegenstände führt.

Es ist von Vorteil, wenn der Lagerkörper an dem Träger festgelegt ist. Dies ermöglicht eine stabile Lagerung der Halteeinrichtung an dem Träger.

Vorzugsweise ist in dem Lagerkörper ein stirnseitiger Anschlag für den Lagerbolzen ausgebildet. Dieser verhindert das Herausbewegen des Lagerbolzens aus dem Lagerkörper in Richtung der umfänglich geschlossenen Aufnahme. Zu diesem Zweck verschließt der stirnseitige Anschlag wenigstens einen Teil der umfänglich geschlossenen Aufnahme des Lagerkörpers auf der der umfänglich offenen Aufnahme abgewandten Seite. Vorteilhafterweise verschließt der stirnseitige Anschlag nur einen Teil der umfänglich geschlossenen Aufnahme, insbesondere den oberen Teil, denn dies ermöglicht den Austritt von Verunreinigungen durch den unteren Teil der umfänglich geschlossenen Aufnahme.

Vorzugsweise liegen das Schwenklager und das weitere Schwenklager für das schwenkbewegliche Lagern der Halteeinrichtung um eine Schwenkachse an dem Träger auf einem Meridian einer Kalotte. Dies hat den Vorteil, dass die Halteeinrichtung durch ihr Eigengewicht in dem Schwenklager gehalten wird und dadurch ein Herausbewegen des Rundkörpers aus dem Schwenklager vermieden wird.

Von Vorteil ist es, wenn die Halteeinrichtung in dem Schwenklager und in dem weiteren Schwenklager in der Richtung der Schwenkachse beweglich verlagerbar angeordnet ist. Dies erleichtert das Einführen der Halteeinrichtung in das Schwenklager und das weitere Schwenklager.

Vorteilhafterweise ist der Lagerkörper des Schwenklagers aus einem Vollmaterial hergestellt, d. h. der Lagerkörper ist aus einem Materialstück hergestellt. Dies hat den Vorteil, dass der Lagerkörper besonders stabil ist. Alternativ hat der Lagerkörper des Schwenklagers einen aus einem Vollmaterial hergestellten ersten Lagerkörperabschnittskörper, in dem die umfänglich geschlossene Aufnahme ausgebildet ist, und einen aus einem Vollmaterial hergestellten weiteren Lagerkörperabschnittskörper, in dem die umfänglich offene Aufnahme ausgebildet ist. Dabei ist der weitere Lagerkörperabschnittskörper an eine Fügefläche des ersten Lagerkörperabschnittskörpers angeschlossen oder von dem ersten Lagerkörperabschnittskörper beabstandet angeordnet. Dies hat den Vorteil, dass ein schon bestehender erster Lagerkörperabschnittskörper, der eine umfänglich geschlossene Öffnung aufweist, um einen weiteren Lagerkörperabschnittskörper erweitert werden kann.

Die dem aufzunehmenden Rundkörper zugewandten Flächen des ersten Lagerkörperabschnittskörpers definieren hier mit der umfänglich geschlossenen Aufnahme und der umfänglich offenen Aufnahme des weiteren Lagerabschnittkörpers möglichst eine stetig differenzierbare Fläche. Mit dieser Maßnahme wird sichergestellt, dass bei einem Herausgleiten des Rundkörpers aus der umfänglich geschlossenen Aufnahme in die umfänglich offene Aufnahme dieser selbsttätig wieder zurück in die umfänglich geschlossene Aufnahme gleiten kann. Ein Versatz der beiden Flächen würde demgegenüber zu einem Verkanten des entsprechenden Rundkörpers führen, so dass dieser dann nicht mehr in die umfänglich geschlossene Aufnahme zurückgleiten kann.

Die Halteeinrichtung zum Halten des Gegenstands in der Beschichtungsöffnung wird mittels des Schwenklagers für das schwenkbewegliche Lagern der Halteeinrichtung um eine Schwenkachse an dem Träger in der Beschichtungsöffnung gewendet. Dafür kann z. B. eine magnetische Kraft zur Drehung der Halteeinrichtung um die Schwenkachse erzeugt werden, welche auf die Halteeinrichtung übertragen wird und die Halteeinrichtung wendet. Ein solches Verfahren zum Wenden der Halteeinrichtung in der Beschichtungsöffnung ist in der DE 10 2006 041 137 B4 beschrieben, auf die hiermit Bezug genommen und deren Offenbarung in die vorliegende Erfindungsbeschreibung vollumfänglich einbezogen wird. Vorzugsweise besteht die Kalotte dabei aus nichtmagnetischem Edelstahl. Weiter vorzugsweise bestehen die Halteeinrichtung und/oder der Gegenstand aus magnetischem Edelstahl.

Die Erfindung betrifft auch ein Verfahren zum Anordnen einer Halteeinrichtung mit einem darin festgelegten Gegenstand für das Beschichten in einer Vakuumbeschichtungsanlage an einem Träger mit einer Beschichtungsöffnung und mit einem an dem Träger oder der Halteeinrichtung festgelegten Lagerkörper mit einer umfänglich geschlossenen Aufnahme für einen in die Richtung einer Schwenkachse erstreckten Rundkörper, der an der Halteeinrichtung oder an dem Träger festgelegt ist, wobei der Lagerkörper zusätzlich eine umfänglich offene Aufnahme für den Rundkörper aufweist, und bei dem durch relatives Verlagern der Halteeinrichtung zu dem Träger der Rundkörper in die umfänglich offene Aufnahme eingelegt und darauf in die umfänglich geschlossene Aufnahme bewegt wird. Diese Art des Anordnens der Halteeinrichtung ist besonders einfach und zeitsparend. Im Vergleich zu der umfänglich geschlossenen Aufnahme weist die umfänglich offene Aufnahme eine größere Öffnung auf und ermöglicht dadurch ein Einführen der Halteeinrichtung in die umfänglich offene Aufnahme aus einer größeren Anzahl von Richtungen - nämlich aus der Richtung der Schwenkachse, aus der Richtung der Öffnung der umfänglich offenen Aufnahme sowie aus allen dazwischen liegenden Richtungen. Auch ein automatisches Einführen der Halteeinrichtung wird dadurch ermöglicht, da die umfänglich offene Aufnahme des Lagerkörpers nicht mehr in drei Raumdimensionen angesteuert werden muss. Stattdessen kann der an die Halteeinrichtung angeschlossene Rundkörper durch die Öffnung der umfänglich offenen Aufnahme in den Lagerkörper eingeführt werden, bis er auf der dem aufzunehmenden Körper zugewandten Wand der umfänglich offenen Aufnahme aufliegt, und dann durch das Eigengewicht der Halteeinrichtung in die umfänglich geschlossene Aufnahme gleiten, bis er den stirnseitigen Anschlag des Lagerkörpers berührt.

Das Verfahren zum Anordnen einer Halteeinrichtung kann Teil eines Verfahrens zum Veredeln eines Gegenstands in einer Vakuumbeschichtungsanlage sein, das die folgenden Verfahrensschritte aufweist: Der Gegenstand wird in einer Halteeinrichtung festgelegt. Die Halteeinrichtung mit dem darin festgelegten Gegenstand wird für das Beschichten in der Vakuumbeschichtungsanlage an einem Träger mit einer Beschichtungsöffnung und mit einem an dem Träger oder der Halteeinrichtung festgelegten Lagerkörper mit einer umfänglich geschlossenen Aufnahme für eine in die Richtung einer Schwenkachse erstreckten Rundkörper, der an der Halteeinrichtung oder an dem Träger festgelegt ist, mit dem oben beschriebenen Verfahren zum Anordnen einer Halteeinrichtung angeordnet. Dabei weist der Lagerkörper zusätzlich eine umfänglich offene Aufnahme für den Rundkörper auf. Schließlich wird der Gegenstand in der Vakuumbeschichtungsanlage beschichtet.

Die Erfindung betrifft weiterhin eine Handhabungsvorrichtung mit einer Steuereinheit, mit einem Greifwerkzeug und mit einer Rechnereinheit, die zur Durchführung des oben angegebenen Verfahrens zum Anordnen einer Halteeinrichtung mit einem darin festgelegten Gegenstand für das Beschichten in einer Vakuumbeschichtungsanlage an einem Träger dient. Die Rechnereinheit enthält ein Computerprogramm mit Programmcode, das Steuerbefehle für die Steuereinheit generiert. Die Steuereinheit dient zum Ansteuern eines Greifwerkzeugs der Handhabungsvorrichtung, welches die Halteeinrichtung mit dem darin festgelegten Gegenstand in die umfänglich offene Aufnahme des Schwenklagers einführt, z. B. in der Richtung der Öffnung der umfänglich offenen Aufnahme, bis der an der Halteeinrichtung angeschlossene Rundkörper auf der dem aufzunehmenden Körper zugewandten Wand der umfänglich offenen Aufnahme aufliegt. Ist das Schwenklager derart orientiert, dass die umfänglich geschlossene Aufnahme tiefer liegt als die umfänglich offene, so lässt das Greifwerkzeug die Halteeinrichtung los, und die Halteeinrichtung mit dem Rundkörper gleitet aufgrund ihres Eigengewichts und der Schwerkraft automatisch von der umfänglich offenen Aufnahme in die umfänglich geschlossene Aufnahme des Lagerkörpers. Liegt die umfänglich geschlossene Aufnahme nicht tiefer als die umfänglich offene Aufnahme, so kann die Handhabungsvorrichtung nach dem Einführen der Halteeinrichtung mit dem Rundkörper diese in die umfänglich geschlossene Aufnahme verlagern. Die umfänglich offene Aufnahme vereinfacht dabei das automatische Einführen.

Ist an dem Träger auch ein weiteres Schwenklager mit einer umfänglich geschlossenen Aufnahme festgelegt, so führt die Handhabungsvorrichtung die Halteeinrichtung mit dem Rundkörper und dem weiteren Rundköper derart in das Schwenklager und das weitere Schwenklager ein, dass zuerst der weitere Rundkörper in die umfänglich geschlossene Öffnung des weiteren Schwenklagers eingeführt wird und danach wie zuvor beschrieben der Rundkörper in das Schwenklager.

Die Erfindung betrifft außerdem ein Computerprogrammprodukt mit einem Computerprogramm mit Programmcode zur Durchführung aller Verfahrensschritte des oben angegebenen Verfahrens zum Anordnen einer Halteeinrichtung, wenn das Computerprogramm in die Rechnereinheit der oben angegebenen Handhabungsvorrichtung geladen und/oder in der Rechnereinheit durchgeführt wird.

Vorteilhafte Ausführungsbeispiele der Erfindung sind in den Zeichnungen schematisch dargestellt und werden nachfolgend beschrieben.

Es zeigen:
- Fig. 1: eine Vakuumbeschichtungsanlage mit einer Vorrichtung zum Aufnehmen von Gegenständen;
- Fig. 2: eine Halteeinrichtung der Vorrichtung;
- Fig. 3: einen Abschnitt eines Trägers der Vorrichtung für das Aufnehmen von Gegenständen mit einer Beschichtungsöffnung;
- Fig. 4: einen Lagerkörper eines Schwenklagers der Vorrichtung für das Aufnehmen von Gegenständen;
- Fig. 5: einen Lagerkörper eines weiteren Schwenklagers der Vorrichtung für das Aufnehmen von Gegenständen;
- Fig. 6: einen zu dem Lagerkörper der Fig. 4 alternativen Lagerkörper des Schwenklagers;
- Fig. 7: die Vakuumbeschichtungsanlage mit einer Handhabungsvorrichtung in einer ersten Pose; und
- Fig. 8: die Vakuumbeschichtungsanlage mit der Handhabungsvorrichtung in einer weiteren Pose.

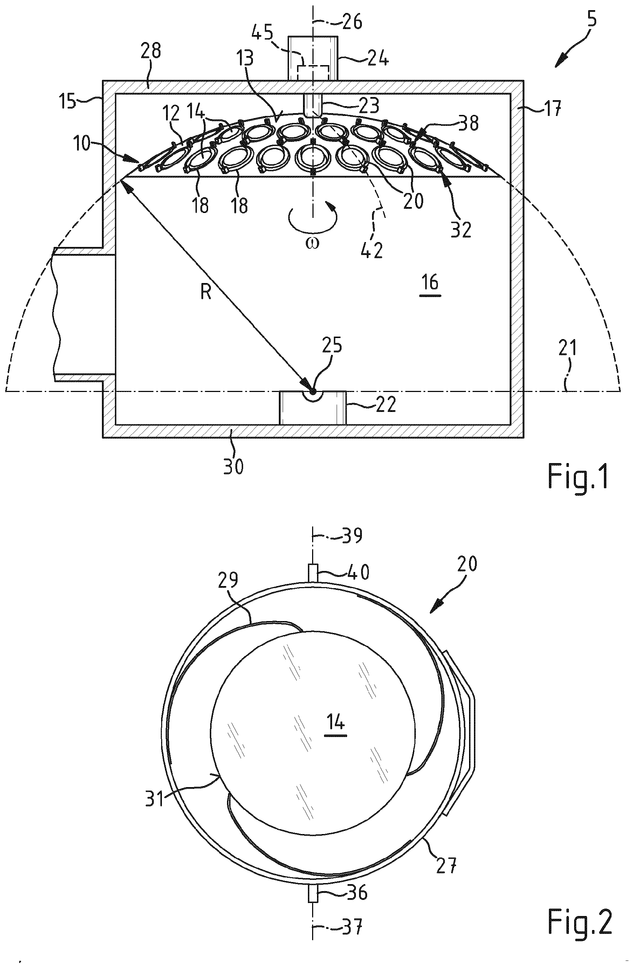

Die Fig. 1 ist ein Schnitt einer Vakuumbeschichtungsanlage 5 mit einer Vorrichtung 10 zum Aufnehmen von Gegenständen 14, die vorliegend als Brillenglaslinsen ausgebildet sind. Die Vakuumbeschichtungsanlage 5 dient für das Beschichten der in der Vorrichtung 10 aufgenommenen Gegenstände 14 mit einer optisch wirksamen Schicht. Die Vakuumbeschichtungsanlage 5 enthält hierzu eine Vakuumkammer 16, in der ein Verdampfungsmaterial mittels eines darin angeordneten Verdampfers 22 im Vakuum verdampft werden kann.

Für das Beschichten von in der Vorrichtung 10 aufgenommenen Gegenstände 14 wird in dem Verdampfer 22 angeordnetes Verdampfungsmaterial durch Erhitzen mit einer elektrischen Heizung (nicht dargestellt) verdampft. Zu bemerken ist, dass die Vakuumbeschichtungsanlage 5 alternativ hierzu insbesondere einen Verdampfer enthalten kann, in dem das Verdampfungsmaterial mittels eines Elektronenstrahls verdampft wird.

Die Vakuumbeschichtungsanlage 5 hat ein Gehäuse 15 mit einer Wand 17 sowie mit einem Boden 30 und mit einer Decke 28, an der die Vorrichtung 10 mit einem Wellenkörper 23 in einem in der Decke 28 festgelegten Drehlager 45 gehalten ist. Die Vorrichtung 10 weist einen an den Wellenkörper 23 angeschlossenen Träger 12 mit einem Körper auf, der eine Kalotte 13 hat. In dem Körper des Trägers 12 sind Beschichtungsöffnungen 18 ausgebildet, an denen eine Brillenglaslinse als ein zu beschichtender Gegenstand 14 mittels einer Halteeinrichtung 20 gehalten werden kann. In der Vakuumbeschichtungsanlage 5 gibt es ein Antriebsmodul 24 für den Wellenkörper 23. Mittels des Antriebsmoduls 24 kann der Wellenkörper 23 mit einer einstellbaren Winkelgeschwindigkeit w um eine vertikale Drehachse 26 bewegt werden. Die Drehachse 26 des Wellenkörpers 23 durchsetzt in der Vakuumbeschichtungsanlage 5 ein Kalottenzentrum 25 der Kalotte 13. Dieses Kalottenzentrum 25 ist unterhalb dem Träger 12 an dem Verdampfer 22 in einem dem Kalottenradius R entsprechenden senkrechten Abstand von der Kalotte 13 des Trägers 12 in der Vakuumkammer 16 angeordnet. Die Beschichtungsöffnungen 18 in dem Körper des Trägers 12 haben an der Kalotte 13 einen kreisförmigen Rand.

Für das Halten der zu beschichtenden Gegenstände 14 in den Beschichtungsöffnungen 18 des Trägers 12 weist die Vorrichtung 10 zum Aufnehmen der Gegenstände 14 eine Vielzahl von Halteeinrichtungen 20 auf. Für eine jede Halteeinrichtung 20 gibt es an dem Träger 12 der Vorrichtung 10 zum Aufnehmen der Gegenstände 14 ein Schwenklager 32 und ein weiteres Schwenklager 38. Die Halteeinrichtungen 20 sind an dem Träger 12 jeweils lösbar in dem Schwenklager 32 und in dem weiteren Schwenklager 38 drehbar gelagert.

Die in den Halteeinrichtungen 20 festgelegten Gegenstände 14 befinden sich in der Vorrichtung 10 an der Kalotte 13 des Trägers 12, d. h. an der Fläche einer Kugel, in deren Zentrum der Verdampfer 22 in der Vakuumbeschichtungsanlage 5 angeordnet ist. Damit wird erreicht, dass auf die zu beschichtenden Gegenstände 14 in der Vakuumbeschichtungsanlage 5 jeweils Schichten mit der gleichen Schichtdicken aufgetragen werden.

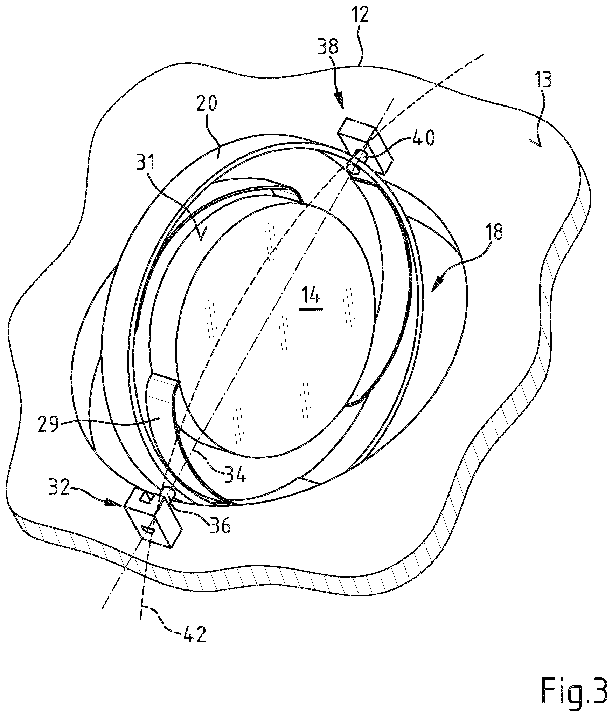

Die Fig. 2 zeigt eine Halteeinrichtung 20 der Vorrichtung 10. In der Fig. 3 ist ein Abschnitt des Trägers 12 mit einer Beschichtungsöffnung 18 und mit einer Halteeinrichtung 20 dargestellt. Die Halteeinrichtung 20 weist einen Wendering 27 auf, an den Federlamellen 29 angeschlossen sind, die eine Brillenglaslinse als einen zu beschichtenden Gegenstand 14 mittels Federkraft an einer seitlichen Randfläche 31 halten.

An den Wendering 27 sind ein Rundkörper 36 mit einer Rundkörperachse 37 und ein weiterer Rundkörper 40 mit einer weiteren Rundkörperachse 39 angeschlossen. Die Rundkörperachse 37 und die weitere Rundkörperachse 39 der Rundkörper 36, 40 des Wenderings 27 verlaufen koaxial zueinander. Die an den Wendering 27 angeschlossenen Rundkörper 36, 40 haben die Form eines Bolzens. Der Rundkörper 36 ist von dem weiteren Rundkörper 40 z. B. im Abstand von 96 mm angeordnet.

Das Schwenklager 32 und das weitere Schwenklager 38 für eine Halteeinrichtung 20 in der Vorrichtung 10 definieren eine Schwenkachse 34. Sie liegen auf einem Meridian 42 der Kalotte 13. Das Schwenklager 32 liegt näher am Äquator 21 der Kalotte 13 und damit tiefer als das weitere Schwenklager 38. Durch das Eigengewicht der Halteeinrichtung 20 wird einem Herausbewegen des Rundkörpers 36 aus dem Lagerkörper des Schwenklagers 32 entgegengewirkt. Die Halteeinrichtung 20 kann mit einem darin gehaltenen Gegenstand 14 durch Drehen um die Schwenkachse 34 in der Vorrichtung 10 gewendet werden, wobei der Wendering 27 in die Beschichtungsöffnung 18 eintaucht. Damit wird ermöglicht, dass in der Vakuumbeschichtungsanlage 5 einander gegenüberliegende Oberflächen der Gegenstände 14 beschichtet werden können. Die umfänglich geschlossene Aufnahme 46 des Schwenklagers 32 und die umfänglich geschlossene Aufnahme 46 des weiteren Schwenklagers 38 sind z. B. in einem Abstand von 90 mm voneinander angeordnet. Die umfänglich offene Aufnahme 48 des Schwenklagers 32 und die umfänglich geschlossene Aufnahme 46 des weiteren Schwenklagers 38 sind z. B. in einem Abstand von 87,7 mm voneinander angeordnet.

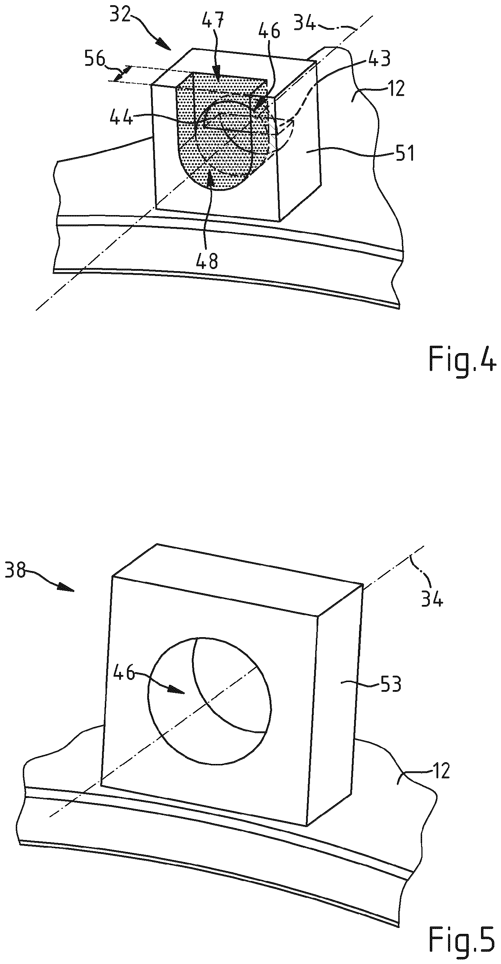

Die Fig. 4 zeigt den Lagerkörper 51 des Schwenklagers 32. In der Fig. 5 ist der Lagerkörper 53 des weiteren Schwenklagers 38 zu sehen. Der Lagerkörper 51 des Schwenklagers 32 ist aus einem Vollmaterial hergestellt. Er ist an dem Träger 12 festgelegt und hat eine umfänglich geschlossene Aufnahme 46 und eine umfänglich offene Aufnahme 48 mit einer mittels des Doppelpfeils 56 kenntlich gemachten Tiefe, in die der Rundkörper 36 oder der weitere Rundkörper 40 eingeführt werden kann. Die umfänglich offene Aufnahme 48 in dem Lagerkörper 51 des Schwenklagers 32 geht dabei in die umfänglich geschlossene Aufnahme 46 des Lagerkörpers 51 über. Die umfänglich offene Aufnahme 48 hat eine U-Form und weist gegenüber dem Rundkörper 36 und dem weiteren Rundkörper 40 ein Übermaß auf. Die umfänglich offene Aufnahme 48 des Lagerkörpers 51 hat eine auf einer dem Träger 12 abgewandten Seite des Lagerkörpers 51 angeordnete Öffnung 47. Die umfänglich geschlossene Aufnahme 46 in dem Schwenklager 32 weist einen Anschlag 44 auf, die eine Bewegung des Rundkörpers 36 oder des weiteren Rundkörpers 40 unterbindet, wenn die Rundkörper 36, 40 mit ihrem stirnseitigen Ende an dem Anschlag 44 anstoßen. Der Lagerkörper 51 des Schwenklagers 32 hat auf einer der umfänglich offenen Aufnahme 48 abgewandten Seite einen Durchbruch mit einer Öffnung 43, der mit der umfänglich geschlossenen Aufnahme 46 kommuniziert und der ein Durchspülen der umfänglich offenen Aufnahme 48 und der umfänglich geschlossenen Aufnahme 46 für Reinigungszwecke ermöglicht.

Das weitere Schwenklager 38 hat einen an dem Träger 12 festgelegten Lagerkörper 53 mit einer umfänglich geschlossenen Aufnahme 46 für den Rundkörper 36 oder den weiteren Rundkörper 40, die als eine Durchgangsbohrung in dem Lagerkörper 53 gestaltet ist.

Die umfänglich geschlossenen Aufnahmen 46 des Schwenklagers 32 und des weiteren Schwenklagers 38 definieren die Schwenkachse 34 für die Halteeinrichtung 20. Die Halteeinrichtung 20 ist in dem Schwenklager 32 und in dem weiteren Schwenklager 38 in der Richtung der Schwenkachse 34 beweglich verlagerbar.

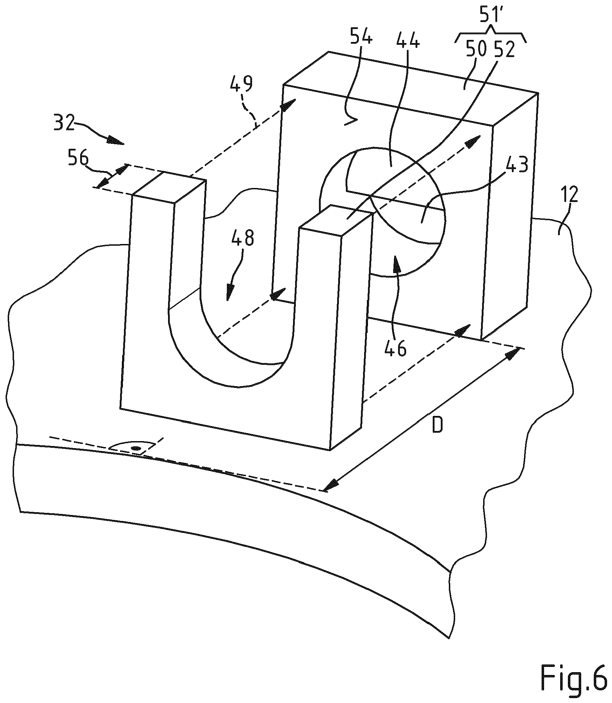

In der Fig. 6 ist ein zu dem in der Fig. 4 gezeigten Lagerkörper 51 des Schwenklagers 32 alternativer Lagerkörper 51' für das Schwenklager 32 zu sehen. Dieser Lagerkörper 51' hat einen aus einem Vollmaterial hergestellten ersten Lagerkörperabschnittskörper 50, in dem die umfänglich geschlossene Aufnahme 46 ausgebildet ist. An den ersten Lagerkörperabschnittskörper 50 ist ein ebenfalls aus einem Vollmaterial hergestellter weiterer Lagerkörperabschnittskörper 52, wie mittels der Pfeile 49 kenntlich gemacht, an eine Fügefläche 54 des ersten Lagerkörperabschnittskörpers 50 angeschlossen. Hier ist die umfänglich offene Aufnahme 48 in dem weiteren Lagerkörperabschnittskörper 52 ausgebildet.

Vorliegend ist der weitere Lagerkörperabschnittskörper 52 an dem ersten Lagerkörperabschnittskörper 50 festgeklebt. Zu bemerken ist, dass der erste Lagerkörperabschnittskörper 50 und der weitere Lagerkörperabschnittskörper 52 auch mittels Schweißen oder Löten verbunden sein können. Alternativ kann der weitere Lagerkörperabschnittskörper 52 auch zu dem ersten Lagerkörperabschnittskörper 50 beabstandet angeordneter Körper sein. Die durch den Doppelpfeil 56 kenntlich gemachte Ausdehnung des weiteren Lagerkörperabschnittskörpers 52 kann zwischen 50% und 100% des Abstands D zwischen dem ersten Lagerkörperabschnittskörper 50 und der Beschichtungsöffnung 18 betragen.

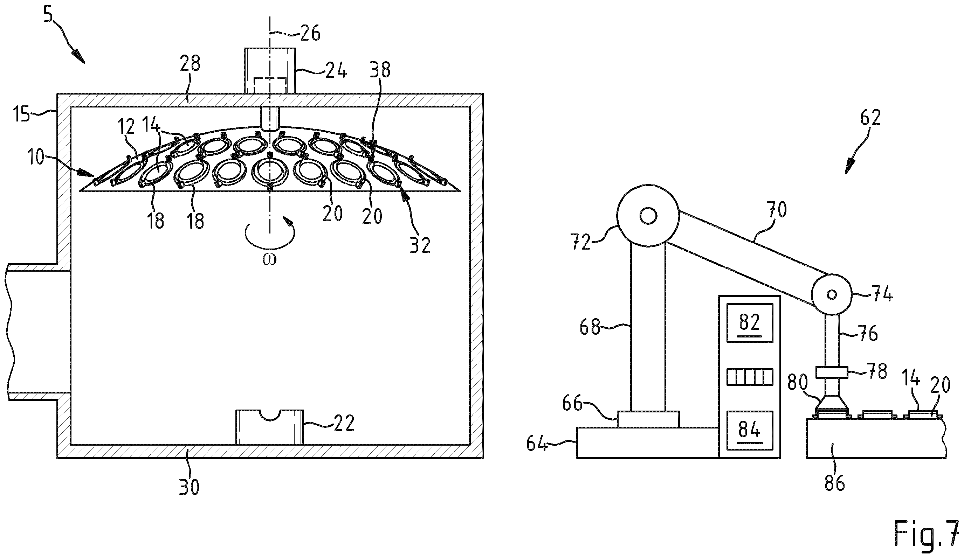

Die Fig. 7 zeigt die Vakuumbeschichtungsanlage 5 mit einer Handhabungsvorrichtung 62, die für das automatische Anordnen einer Halteeinrichtung 20 mit einem darin gehaltenen Gegenstand 14 in dem Schwenklager 32 und in dem weiteren Schwenklager 38 an einer Beschichtungsöffnung 18 des Trägers 12 der Vorrichtung 10 dient.

Die Handhabungsvorrichtung 62 hat einen Sockel 64 mit einem Drehgelenk 66 für einen ersten Roboterarm 68, an dem ein zweiter Roboterarm 70 in einem Schwenkgelenk 72 aufgenommen ist. Der zweite Roboterarm 70 trägt in einem weiteren Schwenkgelenk 74 einen dritten Roboterarm 76, der ein Drehgelenk 78 aufweist, an das ein Greifwerkzeug 80 für das Greifen der Halteeinrichtung 20 mit einem darin gehaltenen Gegenstand 14 angeschlossen ist. Die Handhabungsvorrichtung 62 hat eine Rechnereinheit 82 und eine Steuereinheit 84. Die Rechnereinheit 82 enthält ein Computerprogramm, das Steuerbefehle für die Steuereinheit 84 generiert, um eine mittels eines Zufuhrsystems 86 zugeführte Halteeinrichtung 20 mit einem darin aufgenommenen Gegenstand 14 in einer Halteeinrichtung-Aufnehmpose aufzunehmen.

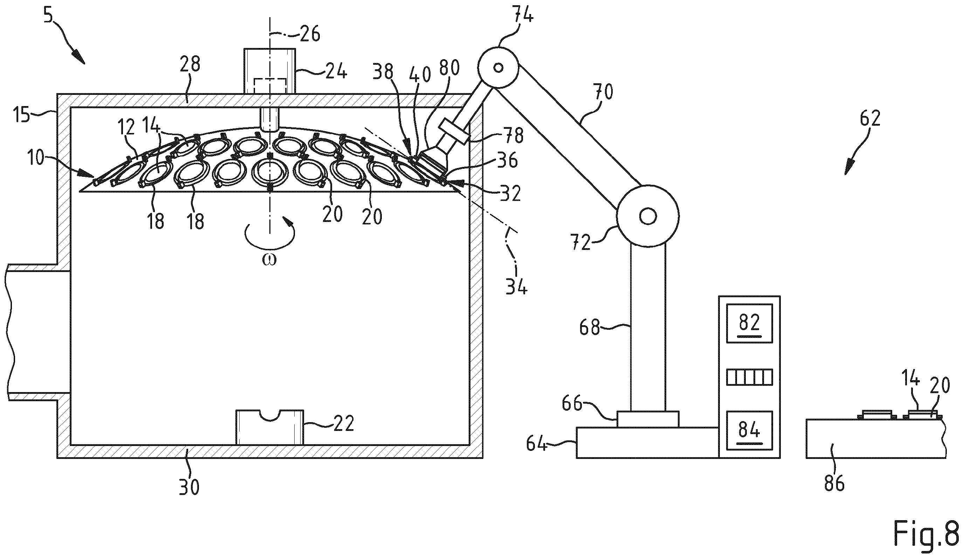

Die Fig. 8 zeigt die Vakuumbeschichtungsanlage 5 mit der Handhabungsvorrichtung 62 in einer Halteeinrichtung-Einlegpose. Hier wird in einem ersten Schritt das Greifwerkzeug 80 mit der darin gehaltenen Halteeinrichtung 20 so bewegt, dass der an dem Wendering 27 angeschlossene weitere Rundkörper 40 in die umfänglich geschlossene Aufnahme 46 des weiteren Schwenklagers 38 eingeführt wird. In einem auf den ersten Schritt folgenden weiteren Schritt wird dann der Rundkörper 36 in die umfänglich offene Aufnahme 48 des Schwenklagers 32 geschwenkt und dann in der Richtung der Schwenkachse 34 in dessen umfänglich geschlossene Aufnahme 46 bewegt.

Zusammenfassend ist Folgendes festzuhalten: Eine Vorrichtung 10 zum Aufnehmen eines Gegenstands 14 in einer Vakuumbeschichtungsanlage 5 enthält einen Träger 12, der eine Beschichtungsöffnung 18 aufweist, und hat eine Halteeinrichtung 20 zum Halten des Gegenstands 14 in der Beschichtungsöffnung 18. In der Vorrichtung 10 gibt es ein Schwenklager 32 für die Halteeinrichtung 20, das an dem Träger 12 festgelegt ist, das eine Schwenkachse 34 hat, um welche die Halteeinrichtung 20 für das Wenden des damit gehaltenen Gegenstands 14 in der Beschichtungsöffnung 18 geschwenkt werden kann und das einen Lagerkörper 51, 51' mit einer umfänglich geschlossenen Aufnahme 46 für einen in die Richtung der Schwenkachse 34 erstreckten Rundkörper 36 hat. Der Lagerkörper 51, 51' weist eine umfänglich geschlossene Aufnahme 46 und eine umfänglich offene Aufnahme 48 für den Rundkörper 36 auf, sodass der Rundkörper 36 bei Anordnen der Halteeinrichtung 20 an dem Träger 12 durch die umfänglich offene Aufnahme 48 in die umfänglich geschlossene Aufnahme 46 eingeführt werden kann.

### Bezugszeichenliste

- 5: Vakuumbeschichtungsanlage
- 10: Vorrichtung
- 12: Träger
- 13: Kalotte
- 14: Gegenstand
- 15: Gehäuse
- 16: Vakuumkammer
- 17: Wand
- 18: Beschichtungsöffnung
- 20: Halteeinrichtung
- 21: Äquator
- 22: Verdampfer
- 23: Wellenkörper
- 24: Antriebsmodul
- 25: Kalottenzentrum
- 26: Drehachse
- 27: Wendering
- 28: Decke
- 29: Federlamellen
- 30: Boden
- 31: Randfläche
- 32: Schwenklager
- 34: Schwenkachse
- 36: Rundkörper
- 37: Rundkörperachse
- 38: weiteres Schwenklager
- 39: weitere Rundkörperachse
- 40: weiterer Rundkörper
- 42: Meridian
- 43: Öffnung
- 44: Anschlag
- 45: Drehlager
- 46: umfänglich geschlossene Aufnahme
- 47: Öffnung
- 48: umfänglich offene Aufnahme
- 49: Pfeile
- 50: erster Lagerkörperabschnittskörper
- 51, 51': Lagerkörper
- 52: weiterer Lagerkörperabschnittskörper
- 53: weiterer Lagerkörper
- 54: Fügefläche
- 56: Doppelpfeil
- 62: Handhabungsvorrichtung
- 64: Sockel
- 66: Drehgelenk
- 68: erster Roboterarm
- 70: zweiter Roboterarm
- 72: Schwenkgelenk
- 74: weiteres Schwenkgelenk
- 76: dritter Roboterarm
- 78: Drehgelenk
- 80: Greifwerkzeug
- 82: Rechnereinheit
- 84: Steuereinheit
- 86: Zufuhrsystem
- R: Kalottenradius
- D: Abstand

## Patentansprüche

1. Vorrichtung (10) zum Aufnehmen eines Gegenstands (14) in einer Vakuumbeschichtungsanlage,
mit einem Träger (12), der eine Beschichtungsöffnung (18) aufweist,
mit einer Halteeinrichtung (20) zum Halten des Gegenstands (14) in der Beschichtungsöffnung (18), und
mit einem Schwenklager (32) für die Halteeinrichtung (20), das an dem Träger (12) festgelegt ist, das eine Schwenkachse (34) hat, um welche die Halteeinrichtung (20) für das Wenden des damit gehaltenen Gegenstands (14) in der Beschichtungsöffnung (18) geschwenkt werden kann und das einen Lagerkörper (51, 51') mit einer umfänglich geschlossenen Aufnahme (46) für einen in die Richtung der Schwenkachse (34) erstreckten Rundkörper (36) hat,
**dadurch gekennzeichnet,**
**dass** der Lagerkörper (51, 51') zusätzlich eine umfänglich offene Aufnahme (48) für den Rundkörper (36) aufweist, wobei der Rundkörper (36) bei Anordnen der Halteeinrichtung (20) an dem Träger (12) durch die umfänglich offene Aufnahme (48) in die umfänglich geschlossene Aufnahme (46) eingeführt werden kann.

2. Vorrichtung (10) nach Anspruch 1, wobei die umfänglich geschlossene Aufnahme (46) des Lagerkörpers (51, 51') in die umfänglich offene Aufnahme (48) des Lagerkörpers (51, 51') übergeht.

3. Vorrichtung (10) nach Anspruch 1 oder 2, wobei der Lagerkörper (51, 51') an dem Träger (12) festgelegt ist,
und/oder
dass die umfänglich offene Aufnahme (48) des Lagerkörpers (51, 51') zwischen der Beschichtungsöffnung (18) des Trägers (12) und der umfänglich geschlossenen Aufnahme (46) des Lagerkörpers (51, 51') angeordnet ist, wobei die Ausdehnung der umfänglich offenen Aufnahme (48) des Lagerkörpers (51, 51') in Richtung der Schwenkachse (34) wenigstens 50% und maximal 100% des Abstands (D) zwischen der umfänglich geschlossenen Aufnahme (46) des Lagerkörpers (51, 51') und der Beschichtungsöffnung (18) beträgt,
und/oder
dass die umfänglich offene Aufnahme (48) des Lagerkörpers (51, 51') eine auf einer dem Träger (12) abgewandten Seite des Lagerkörpers (51, 51') angeordnete Öffnung (47) hat,
und/oder
dass die umfänglich offene Aufnahme (48) des Lagerkörpers (51, 51') eine U-Form aufweist.

4. Vorrichtung nach einem der Ansprüche 1 bis 3, wobei der Rundkörper (36) ein an die Halteeinrichtung (20) angeschlossener Lagerbolzen ist.

5. Vorrichtung nach Anspruch 4, wobei die umfänglich geschlossene Aufnahme (46) gegenüber dem Rundkörper (36) ein Übermaß hat.

6. Vorrichtung nach einem der Ansprüche 1 bis 5, wobei ein weiteres Schwenklager (38) für das schwenkbewegliche Lagern der Halteeinrichtung (20) um eine Schwenkachse (34) an dem Träger (12) vorgesehen ist, das für das Wenden des mit der Halteeinrichtung (20) gehaltenen Gegenstands (14) in der Beschichtungsöffnung (18) dient, das einen weiteren Lagerkörper (53) mit einer umfänglich geschlossenen Aufnahme (46) für einen in die Richtung der Schwenkachse (34) erstreckten weiteren Rundkörper (40) hat.

7. Vorrichtung nach Anspruch 6, wobei der weitere Lagerkörper (53) eine umfänglich geschlossene Aufnahme (46) und eine umfänglich offene Aufnahme (48) für den weiteren Rundkörper (40) aufweist, sodass der weitere Rundkörper (40) bei Anordnen der Halteeinrichtung (20) an dem Träger (12) durch die umfänglich offene Aufnahme (48) in die umfänglich geschlossene Aufnahme (46) eingeführt werden kann,
und/oder
dass der weitere Lagerkörper (53) an dem Träger (12) festgelegt ist.

8. Vorrichtung nach Anspruch 6 oder 7, wobei der weitere Rundkörper (40) ein an die Halteeinrichtung (20) angeschlossener Lagerbolzen ist.

9. Vorrichtung nach Anspruch 8, wobei in dem Lagerkörper (51, 51') des Schwenklagers (32) ein stirnseitiger Anschlag (44) für den Lagerbolzen ausgebildet ist.

10. Vorrichtung nach einem der Ansprüche 6 bis 9, wobei das Schwenklager (32) und das weitere Schwenklager (38) für das schwenkbewegliche Lagern der Halteeinrichtung (20) um eine Schwenkachse (34) an dem Träger auf einem Meridian (42) einer Kalotte (13) liegen, und/oder dass die Halteeinrichtung (20) in dem Schwenklager (32) und in dem weiteren Schwenklager (38) in der Richtung der Schwenkachse (34) beweglich verlagerbar angeordnet ist.

11. Vorrichtung nach einem der Ansprüche 1 bis 10, wobei der Lagerkörper (51, 51') des Schwenklagers (32) aus einem Vollmaterial hergestellt ist; oder dass der Lagerkörper (51, 51') des Schwenklagers (32) einen aus einem Vollmaterial hergestellten ersten Lagerkörperabschnittskörper (50) hat, in dem die umfänglich geschlossene Aufnahme (46) ausgebildet ist, und einen aus einem Vollmaterial hergestellten weiteren Lagerkörperabschnittskörper (52) hat, in dem die umfänglich offene Aufnahme (48) ausgebildet ist, der an eine Fügefläche (54) des ersten Lagerkörperabschnittskörpers (50) angeschlossen ist oder der von dem ersten Lagerkörperabschnittskörper (50) beabstandet angeordnet ist.

12. Verfahren zum Anordnen einer Halteeinrichtung (20) mit einem darin festgelegten Gegenstand (14) für das Beschichten in einer Vakuumbeschichtungsanlage (5) an einem Träger (12) mit einer Beschichtungsöffnung (18) und mit einem an dem Träger (12) oder der Halteeinrichtung (20) festgelegten Lagerkörper (51, 51') mit einer umfänglich geschlossenen Aufnahme (46) für eine in die Richtung einer Schwenkachse (34) erstreckten Rundkörper (36), der an der Halteeinrichtung (20) oder an dem Träger (12) festgelegt ist,
**dadurch gekennzeichnet, dass**
der Lagerkörper (51, 51') zusätzlich eine umfänglich offene Aufnahme (48) für den Rundkörper (36) aufweist, und
bei dem durch relatives Verlagern der Halteeinrichtung (20) zu dem Träger (12) der Rundkörper (36) in die umfänglich offene Aufnahme (48) eingelegt und darauf in die umfänglich geschlossene Aufnahme (46) bewegt wird.

13. Verfahren zum Veredeln eines Gegenstands (14) in einer Vakuumbeschichtungsanlage mit den folgenden Verfahrensschritten:
Festlegen des Gegenstands (14) in einer Halteeinrichtung (20);
Anordnen der Halteeinrichtung (20) mit dem darin festgelegten Gegenstand (14) für das Beschichten in der Vakuumbeschichtungsanlage (5) an einem Träger (12) mit einer Beschichtungsöffnung (18) und mit einem an dem Träger (12) oder der Halteeinrichtung (20) festgelegten Lagerkörper (51, 51') mit einer umfänglich geschlossenen Aufnahme (46) für eine in die Richtung einer Schwenkachse (34) erstreckten Rundkörper (36), der an der Halteeinrichtung (20) oder an dem Träger (12) festgelegt ist, und
Beschichten des Gegenstands (14) in der Vakuumbeschichtungsanlage,
**dadurch gekennzeichnet, dass**
der Lagerkörper (51, 51') zusätzlich eine umfänglich offene Aufnahme (48) für den Rundkörper (36) aufweist,
wobei die Halteeinrichtung (20) an dem Träger (12) mit dem in Anspruch 12 angegebenen Verfahren angeordnet wird.

14. Handhabungsvorrichtung (62) mit einer Steuereinheit (84), mit einem Greifwerkzeug (80) und mit einer Rechnereinheit (82), die zur Durchführung des in Anspruch 12 angegebenen Verfahrens zum Anordnen einer Halteeinrichtung (20) mit einem darin festgelegten Gegenstand (14) für das Beschichten in einer Vakuumbeschichtungsanlage (5) an einem Träger (12) dient,
wobei die Rechnereinheit ein Computerprogramm mit einem Programmcode enthält, das Steuerbefehle für die Steuereinheit generiert,
wobei die Steuereinheit (84) zum Ansteuern des Greifwerkzeugs (80) der Handhabungsvorrichtung (62) dient,
wobei das Greifwerkzeug (80) zum Einführen der Halteeinrichtung (20) mit dem darin festgelegten Gegenstand (14) in eine umfänglich offene Aufnahme (48) eines Lagerkörpers (51, 51') eines Schwenklagers (32) für einen an die Halteeinrichtung (20) angeschlossenen Rundkörper (36), bis der an der Halteeinrichtung (20) angeschlossene Rundkörper (36) auf der einem aufzunehmenden Körper zugewandten Wand der umfänglich offenen Aufnahme (48) aufliegt, ausgelegt ist,
um die Halteeinrichtung (20) mit dem Rundkörper (36) mittels des Greifwerkzeugs (80) darauf in eine umfänglich geschlossene Aufnahme (46) für den Rundkörper (36) einzuführen.

15. Computerprogrammprodukt mit einem Computerprogramm mit Programmcode zur Durchführung aller Verfahrensschritte, die in Anspruch 13 angegeben sind, wenn das Computerprogramm in die Rechnereinheit (82) der Handhabungsvorrichtung (62) nach Anspruch 14 geladen und/oder in der Rechnereinheit (82) durchgeführt wird.

## Claims

1. Apparatus (10) for receiving an object (14) in a vacuum coating installation,
comprising a carrier (12) which has a coating opening (18),
comprising a holding device (20) for holding the object (14) in the coating opening (18), and
comprising a pivot bearing (32) for the holding device (20), which pivot bearing is secured to the carrier (12), has a pivot axis (34) about which the holding device (20) can be pivoted for turning the object (14) that it holds in the coating opening (18), and has a bearing body (51, 51') with a circumferentially closed receptacle (46) for a round body (36) with an extent in the direction of the pivot axis (34),
**characterized**
**in that** the bearing body (51, 51') additionally has a circumferentially open receptacle (48) for the round body (36), wherein the round body (36) can be inserted into the circumferentially closed receptacle (46) through the circumferentially open receptacle (48) when the holding device (20) is being arranged on the carrier (12).

2. Apparatus (10) according to Claim 1, wherein the circumferentially closed receptacle (46) of the bearing body (51, 51') merges into the circumferentially open receptacle (48) of the bearing body (51, 51').

3. Apparatus (10) according to Claim 1 or 2, wherein the bearing body (51, 51') is secured to the carrier (12),
and/or
in that the circumferentially open receptacle (48) of the bearing body (51, 51') is arranged between the coating opening (18) of the carrier (12) and the circumferentially closed receptacle (46) of the bearing body (51, 51'), wherein the extent of the circumferentially open receptacle (48) of the bearing body (51, 51') in the direction of the pivot axis (34) amounts to at least 50% and at most 100% of the distance (D) between the circumferentially closed receptacle (46) of the bearing body (51, 51') and the coating opening (18),
and/or
in that the circumferentially open receptacle (48) of the bearing body (51, 51') has an opening (47) arranged on a side of the bearing body (51, 51') that faces away from the carrier (12),
and/or
in that the circumferentially open receptacle (48) of the bearing body (51, 51') has a U shape.

4. Apparatus according to one of Claims 1 to 3, wherein the round body (36) is a mounting pin attached to the holding device (20).

5. Apparatus according to Claim 4, wherein the circumferentially closed receptacle (46) has an oversize in relation to the round body (36).

6. Apparatus according to one of Claims 1 to 5, wherein a further pivot bearing (38) is provided for mounting the holding device (20) on the carrier (12) so as to be able to pivot about a pivot axis (34), which further pivot bearing serves for turning the object (14) held by the holding device (20) in the coating opening (18) and has a further bearing body (53) with a circumferentially closed receptacle (46) for a further round body (40) with an extent in the direction of the pivot axis (34).

7. Apparatus according to Claim 6, wherein the further bearing body (53) has a circumferentially closed receptacle (46) and a circumferentially open receptacle (48) for the further round body (40), with the result that the further round body (40) can be inserted into the circumferentially closed receptacle (46) through the circumferentially open receptacle (48) when the holding device (20) is being arranged on the carrier (12),
and/or
in that the further bearing body (53) is secured to the carrier (12).

8. Apparatus according to Claim 6 or 7, wherein the further round body (40) is a mounting pin attached to the holding device (20).

9. Apparatus according to Claim 8, wherein an end-face stop (44) for the mounting pin is formed in the bearing body (51, 51') of the pivot bearing (32).

10. Apparatus according to one of Claims 6 to 9, wherein the pivot bearing (32) and the further pivot bearing (38) for mounting the holding device (20) on the carrier so as to be able to pivot about a pivot axis (34) lie on a meridian (42) of a spherical cap (13), and/or in that the holding device (20) is arranged in the pivot bearing (32) and in the further pivot bearing (38) so as to be displaceable in the direction of the pivot axis (34).

11. Apparatus according to one of Claims 1 to 10, wherein the bearing body (51, 51') of the pivot bearing (32) is produced from a solid material; or in that the bearing body (51, 51') of the pivot bearing (32) has a first bearing body portion body (50), which is produced from a solid material and in which the circumferentially closed receptacle (46) is formed, and a further bearing body portion body (52), which is produced from a solid material, in which the circumferentially open receptacle (48) is formed, and which is attached to a joining surface (54) of the first bearing body portion body (50) or is spaced apart from the first bearing body portion body (50) .

12. Method for arranging a holding device (20), comprising an object (14) secured therein, for the purpose of being coated in a vacuum coating installation (5), on a carrier (12) having a coating opening (18) and having a bearing body (51, 51'), which is secured to the carrier (12) or the holding device (20) and has a circumferentially closed receptacle (46) for a round body (36) that has an extent in the direction of a pivot axis (34) and is secured to the holding device (20) or to the carrier (12),
**characterized in that**
the bearing body (51, 51') additionally has a circumferentially open receptacle (48) for the round body (36), and
in which method, by relatively displacing the holding device (20) with respect to the carrier (12), the round body (36) is inserted into the circumferentially open receptacle (48) and thereafter moved into the circumferentially closed receptacle (46).

13. Method for improving the finish of an object (14) in a vacuum coating installation, having the following method steps:
securing the object (14) in a holding device (20);
arranging the holding device (20), comprising the object (14) secured therein, for the purpose of being coated in the vacuum coating installation (5), on a carrier (12) having a coating opening (18) and having a bearing body (51, 51'), which is secured to the carrier (12) or the holding device (20) and has a circumferentially closed receptacle (46) for a round body (36) that has an extent in the direction of a pivot axis (34) and is secured to the holding device (20) or to the carrier (12), and
coating the object (14) in the vacuum coating installation,
**characterized in that**
the bearing body (51, 51') additionally has a circumferentially open receptacle (48) for the round body (36),
wherein the holding device (20) is arranged on the carrier (12) by the method specified in Claim 12.

14. Handling apparatus (62) having a control unit (84), having a gripping tool (80) and having a computer unit (82), which serves to carry out the method specified in Claim 12 for arranging a holding device (20), comprising an object (14) secured therein, for the purpose of being coated in a vacuum coating installation (5), on a carrier (12),
wherein the computer unit contains a computer program having a program code which generates control commands for the control unit,
wherein the control unit (84) serves to actuate the gripping tool (80) of the handling apparatus (62), wherein the gripping tool (80) is designed to insert the holding device (20), comprising the object (14) secured therein, into a circumferentially open receptacle (48) of a bearing body (51, 51') of a pivot bearing (32) for a round body (36) attached to the holding device (20), until the round body (36) attached to the holding device (20) lies against that wall of the circumferentially open receptacle (48) that faces a body to be received,
in order thereafter to insert the holding device (20) comprising the round body (36) into a circumferentially closed receptacle (46) for the round body (36) by means of the gripping tool (80).

15. Computer program product comprising a computer program having program code for carrying out all the method steps specified in Claim 13 when the computer program is loaded on the computer unit (82) of the handling apparatus (62) according to Claim 14 and/or executed on the computer unit (82).

## Revendications

1. Dispositif (10) pour recevoir un article (14) dans une installation de revêtement sous vide,
avec un support (12), qui présente une ouverture de revêtement (18),
avec un appareil de maintien (20) pour maintenir l'article (14) dans l'ouverture de revêtement (18), et avec un palier de pivotement (32) pour l'appareil de maintien (20), qui est fixé au support (12), qui a un axe de pivotement (34) autour duquel l'appareil de maintien (20) peut être pivoté pour le retournement de l'article (14) maintenu par celui-ci dans l'ouverture de revêtement (18), et qui a un corps de palier (51, 51') avec un logement circonférentiellement fermé (46) pour un corps circulaire (36) s'étendant dans la direction de l'axe de pivotement (34),
**caractérisé en ce que**
le corps de palier (51, 51') présente en outre un logement circonférentiellement ouvert (48) pour le corps circulaire (36), le corps circulaire (36) pouvant être inséré dans le logement circonférentiellement fermé (46) à travers le logement circonférentiellement ouvert (48) lors de l'agencement du l'appareil de maintien (20) sur le support (12).

2. Dispositif (10) selon la revendication 1, dans lequel le logement circonférentiellement fermé (46) du corps de palier (51, 51') se raccorde au logement circonférentiellement ouvert (48) du corps de palier (51, 51') .

3. Dispositif (10) selon la revendication 1 ou 2, dans lequel le corps de palier (51, 51') est fixé au support (12),
et/ou
le logement circonférentiellement ouvert (48) du corps de palier (51, 51') est agencé entre l'ouverture de revêtement (18) du support (12) et le logement circonférentiellement fermé (46) du corps de palier (51, 51'), l'extension du logement circonférentiellement ouvert (48) du corps de palier (51, 51') en direction de l'axe de pivotement (34) étant égale au moins à 50 % et au maximum à 100 % de la distance (D) entre le logement circonférentiellement fermé (46) du corps de palier (51, 51') et l'ouverture de revêtement (18),
et/ou
le logement circonférentiellement ouvert (48) du corps de palier (51, 51') a une ouverture (47) agencée sur un côté du corps de palier (51, 51') détourné du support (12),
et/ou
le logement circonférentiellement ouvert (48) du corps de palier (51, 51') présente une forme en U.

4. Dispositif selon l'une quelconque des revendications 1 à 3, dans lequel le corps circulaire (36) est un axe de palier raccordé à l'appareil de maintien (20).

5. Dispositif selon la revendication 4, dans lequel le logement circonférentiellement fermé (46) a une surmesure par rapport au corps circulaire (36).

6. Dispositif selon l'une quelconque des revendications 1 à 5, dans lequel il est prévu un autre palier de pivotement supplémentaire (38) pour le montage mobile en pivotement de l'appareil de maintien (20) autour d'un axe de pivotement (34) sur le support (12), lequel palier sert au retournement de l'article (14) maintenu par l'appareil de maintien (20) dans l'ouverture de revêtement (18), lequel palier a un corps de palier supplémentaire (53) avec un logement circonférentiellement fermé (46) pour un corps circulaire supplémentaire (40) s'étendant dans la direction de l'axe de pivotement (34).

7. Dispositif selon la revendication 6, dans lequel le corps de palier supplémentaire (53) présente un logement circonférentiellement fermé (46) et un logement circonférentiellement ouvert (48) pour le corps circulaire supplémentaire (40), de telle sorte que le corps circulaire supplémentaire (40) peut être inséré dans le logement circonférentiellement fermé (46) à travers le logement circonférentiellement ouvert (48) lors de l'agencement de l'appareil de maintien (20) sur le support (12),
et/ou
le corps de palier supplémentaire (53) est fixé au support (12).

8. Dispositif selon la revendication 6 ou 7, dans lequel le corps circulaire supplémentaire (40) est un axe de palier raccordé à l'appareil de maintien (20).

9. Dispositif selon la revendication 8, dans lequel une butée frontale (44) pour l'axe de palier est réalisée dans le corps de palier (51, 51') du palier de pivotement (32) .

10. Dispositif selon l'une quelconque des revendications 6 à 9, dans lequel le palier de pivotement (32) et le palier de pivotement supplémentaire (38) sont situés sur un méridien (42) d'une calotte (13) pour le montage mobile en pivotement de l'appareil de maintien (20) autour d'un axe de pivotement (34) sur le support, et/ou l'appareil de maintien (20) est agencé dans le palier de pivotement (32) et dans le palier de pivotement supplémentaire (38) de manière à pouvoir être déplacé dans la direction de l'axe de pivotement (34).

11. Dispositif selon l'une quelconque des revendications 1 à 10, dans lequel le corps de palier (51, 51') du palier de pivotement (32) est fabriqué dans un matériau plein ; ou le corps de palier (51, 51') du palier de pivotement (32) a un premier corps de section de corps de palier (50) fabriqué dans un matériau plein, dans lequel le logement circonférentiellement fermé (46) est réalisé, et un corps de section de corps de palier supplémentaire (52) fabriqué dans un matériau plein, dans lequel est réalisé le logement circonférentiellement ouvert (48), qui est raccordé à une surface de joint (54) du premier corps de section de corps de palier (50) ou qui est agencé en étant espacé du premier corps de section de corps de palier (50).

12. Procédé d'agencement d'un appareil de maintien (20), avec un article (14) qui y est fixé, pour le revêtement dans une installation de revêtement sous vide (5) sur un support (12) avec une ouverture de revêtement (18) et avec un corps de palier (51, 51') fixé au support (12) ou à l'appareil de maintien (20), avec un logement circonférentiellement fermé (46) pour un corps circulaire (36) s'étendant dans la direction d'un axe de pivotement (34), qui est fixé à l'appareil de maintien (20) ou au support (12),
**caractérisé en ce que**
le corps de palier (51, 51') présente en outre un logement circonférentiellement ouvert (48) pour le corps circulaire (36), et
dans lequel, par déplacement relatif de l'appareil de maintien (20) par rapport au support (12), le corps circulaire (36) est placé dans le logement circonférentiellement ouvert (48) et est ensuite déplacé dans le logement circonférentiellement fermé (46).

13. Procédé de finition d'un article (14) dans une installation de revêtement sous vide, avec les étapes de procédé suivantes :
la fixation de l'article (14) dans un appareil de maintien (20) ;
l'agencement de l'appareil de maintien (20), avec l'article (14) qui y est fixé, pour le revêtement dans l'installation de revêtement sous vide (5) sur un support (12) avec une ouverture de revêtement (18) et avec un corps de palier (51, 51') fixé au support (12) ou à l'appareil de maintien (20), avec un logement circonférentiellement fermé (46) pour un corps circulaire (36) s'étendant dans la direction d'un axe de pivotement (34), qui est fixé à l'appareil de maintien (20) ou au support (12), et
le revêtement de l'article (14) dans l'installation de revêtement sous vide,
**caractérisé en ce que**
le corps de palier (51, 51') présente en outre un logement circonférentiellement ouvert (48) pour le corps circulaire (36),
l'appareil de maintien (20) étant agencé sur le support (12) par le procédé indiqué dans la revendication 12.

14. Dispositif de manipulation (62) avec une unité de commande (84), avec un outil de préhension (80) et avec une unité de calcul (82), qui sert à exécuter le procédé indiqué dans la revendication 12 pour agencer sur un support (12) un appareil de maintien (20), avec un article (14) qui y est fixé, pour le revêtement dans une installation de revêtement sous vide (5),
l'unité de calcul contenant un programme informatique avec un code de programme qui génère des instructions de commande pour l'unité de commande,
l'unité de commande (84) servant à commander l'outil de préhension (80) du dispositif de manipulation (62), l'outil de préhension (80) étant conçu pour insérer l'appareil de maintien (20), avec l'article (14) qui y est fixé, dans un logement circonférentiellement ouvert (48) d'un corps de palier (51, 51') d'un palier de pivotement (32) pour un corps circulaire (36) raccordé à l'appareil de maintien (20), jusqu'à ce que le corps circulaire (36) raccordé à l'appareil de maintien (20) repose sur la paroi du logement circonférentiellement ouvert (48), qui est tournée vers un corps à recevoir, afin d'insérer l'appareil de maintien (20) avec le corps circulaire (36) au moyen de l'outil de préhension (80) dans un logement circonférentiellement fermé (46) pour le corps circulaire (36).

15. Produit de programme informatique avec un programme informatique avec un code de programme pour exécuter toutes les étapes de procédé indiquées dans la revendication 13 lorsque le programme informatique est chargé dans l'unité de calcul (82) du dispositif de manipulation (62) selon la revendication 14 et/ou est exécuté dans l'unité de calcul (82).
